# EUROPÄISCHE PATENTSCHRIFT

(11) **EP 2 208 240 B1**
(45) Veröffentlichungstag und Bekanntmachung des Hinweises auf die Patenterteilung: **29.08.2018**
(21) Anmeldenummer: 08801326.3
(22) Anmeldetag: 12.09.2008
(51) Int. Cl.: H01L 33/06, H01S 5/343

(54) **OPTOELEKTRONISCHER HALBLEITERCHIP MIT EINER MEHRFACHQUANTENTOPFSTRUKTUR**
OPTOELECTRONIC SEMICONDUCTOR CHIP HAVING A MULTIPLE QUANTUM WELL STRUCTURE
PUCE SEMI-CONDUCTRICE OPTOÉLECTRONIQUE À STRUCTURE DE PUITS QUANTIQUES MULTIPLES

(30) Priorität: 26.09.2007 DE 102007046027
(43) Veröffentlichungstag der Anmeldung: 21.07.2010
(73) Patentinhaber: OSRAM Opto Semiconductors GmbH, 93055 Regensburg (DE)
(72) Erfinder: STAUSS, Peter, 93186 Pettendorf (DE); PETER, Matthias, 93087 Alteglofsheim (DE); WALTER, Alexander, 93164 Laaber (DE)
(74) Vertreter: Epping - Hermann - Fischer
(86) Internationale Anmeldenummer: PCT/DE2008/001534
(87) Internationale Veröffentlichungsnummer: WO 2009/039830

(56) Entgegenhaltungen:
- EP-A- 1 076 390
- EP-A- 1 385 241
- EP-A- 1 564 854
- US-A1- 2003 205 736
- US-A1- 2004 031 978
- US-A1- 2005 156 153
- US-A1- 2006 043 356

## Beschreibung

Diese Patentanmeldung beansprucht die Priorität der deutschen Patentanmeldung 102007046027.0, deren Offenbarungsgehalt hiermit durch Rückbezug aufgenommen wird.

Die vorliegende Anmeldung betrifft einen optoelektronischen Halbleiterchip mit einer Mehrfachquantentopfstruktur.

Optoelektronische Halbleiterchips mit Mehrfachquantentopfstruktur sind beispielsweise in den Druckschriften WO 01/39282 A2, US 5,831,277, EP 1 385 241 A1, US 2005/0156153 A1, US 2006/0043356 A1 und EP 1 076 390 A2 offenbart.

Es ist eine Aufgabe der vorliegenden Anmeldung, einen optoelektronischen Halbleiterchip mit einer Mehrfachquantentopfstruktur anzugeben, der besonders effizient ist.

Diese Aufgabe wird durch einen optoelektronischen Halbleiterchip gemäß Anspruch 1 gelöst. Vorteilhafte Ausgestaltungen und Weiterbildungen des Halbleiterchips sind in den abhängigen Ansprüchen angegeben. Der Offenbarungsgehalt der Patentansprüche wird hiermit ausdrücklich durch Rückbezug in die Beschreibung aufgenommen.

Es wird ein optoelektronischer Halbleiterchip angegeben, der eine aktive Zone aufweist, welche eine zur Erzeugung von elektromagnetischer Strahlung vorgesehene Mehrfachquanten topfstruktur enthält. Die aktive Zone ist insbesondere ein Teilbereich einer epitaktischen Halbleiterschichtenfolge. Bei dem Halbleiterchip handelt es sich beispielsweise um einen Leuchtdiodenchip oder um einen Laserdiodenchip.

Die aktive Zone enthält eine Mehrzahl von aufeinander folgenden Quantentopfschichten. Zweckmäßigerweise ist jede Quantentopfschicht zwischen zwei ihr zugeordneten Barriereschichten angeordnet. Mit anderen Worten folgen in der aktiven Zone jeweils eine Barriereschicht und eine Quantentopfschicht aufeinander. Jeder Quantentopfschicht geht insbesondere eine ihr zugeordnete Barriereschicht voraus und eine ihr zugeordnete weitere Barriereschicht folgt ihr nach. Die Angaben "vorausgehend" und "nachfolgend" sind im vorliegenden Zusammenhang jeweils in Richtung von einer n-Seite zu einer p-Seite des Halbleiterchips, zwischen welchen die aktive Zone angeordnet ist, zu verstehen.

Die Begriffe "Mehrfachquantentopfstruktur" und "Quantentopfschicht" entfalten im vorliegenden Zusammenhang keine Bedeutung hinsichtlich der Dimensionalität der Quantisierung. Bei dem von einer Quantentopfschicht und den beiden ihr zugeordneten Barriereschichten definierten Quantentopf kann es sich um einen Quantenfilm, um mindestens einen Quantendraht oder um mindestens einen Quantenpunkt oder um eine Kombination von mindestens zwei dieser Strukturen handeln.

Die Mehrfachquantentopfstruktur weist mindestens eine erste Quantentopfschicht auf, die n-leitend dotiert ist und die zwischen zwei an die erste Quantentopfschicht angrenzenden, n-leitend dotierten Barriereschichten angeordnet ist. Anders ausgedrückt sind insbesondere sowohl die erste Quantentopfschicht als auch die ihr zugeordneten zwei Barriereschichten n-leitend dotiert.

Unter einer n-leitend dotierten Schicht wird im vorliegenden Zusammenhang eine mit mindestens einem n-Dotierstoff wie Silizium dotierte Schicht verstanden. Es ist denkbar, dass zwei verschiedene Schichten, etwa eine Quantentopfschicht und eine Barriereschicht, mit unterschiedlichen n-Dotierstoffen n-leitend dotiert sind. Vorzugsweise sind alle n-leitend dotierten Quantentopf- und Barriereschichten mit dem gleichen n-Dotierstoff oder mit den gleichen n-Dotierstoffen dotiert.

Die Mehrfachquantentopfstruktur weist weiter mindestens eine, vorzugsweise genau eine zweite Quantentopfschicht auf, die undotiert ist und die zwischen zwei an die zweite Quantentopfschicht angrenzenden Barriereschichten angeordnet ist, von denen eine n-leitend dotiert und die andere undotiert ist. Beispielsweise folgt die zweite Quantentopfschicht der ersten Quantentopfschicht nach. Insbesondere ist die der zweiten Quantentopfschicht vorausgehende Barriereschicht n-leitend dotiert und die der zweiten Quantentopfschicht nachfolgende Barriereschicht ist undotiert.

Unter einer undotierten Schicht wird vorliegend eine Schicht verstanden, die im Wesentlichen frei von einem n-Dotierstoff oder p-Dotierstoff ist. Eine undotierte Schicht kann jedoch - zum Beispiel aufgrund von Diffusion eines n- und/oder p-Dotierstoffs - auch eine geringen Konzentration, insbesondere eine verschwindend geringe Konzentration, des n- und/oder p-Dotierstoffs aufweisen. Ein n-Dotierstoff liegt insbesondere in einer geringen Konzentration in der undotierten Schicht vor, wenn seine Konzentration in der undotierten Schicht um mindestens 40 Prozent kleiner, vorzugsweise um mindestens 70 Prozent kleiner ist, als die Konzentration des n-Dotierstoffs in der ersten Quantentopfschicht.

Schließlich weist die Mehrfachquantentopfstruktur mindestens eine dritte Quantentopfschicht auf, die undotiert ist und zwischen zwei an die dritte Quantentopfschicht angrenzenden, ebenfalls undotierten Barriereschichten angeordnet ist. Zweckmäßigerweise ist die dritte Quantentopfschicht der zweiten Quantentopfschicht nachfolgend in der aktiven Zone angeordnet.

Die Erfinder haben festgestellt, dass mittels einer solchen Abfolge der ersten, zweiten und dritten Quantentopfschicht(en) eine besonders hohe Effizienz des Halbleiterchips erzielt wird. Insbesondere ist bei hohen Betriebsströmen die Effizienz gegenüber herkömmlichen Halbleiterchips erhöht. Der optoelektronische Halbleiterchips ist beispielsweise zum Betrieb mit einem Betriebsstrom von größer oder gleich 80 mA vorgesehen.

Bei einer Ausgestaltung weist die Mehrfachquantentopfstruktur mindestens eine vierte Quantentopfschicht auf, die undotiert ist und die zwischen zwei an die vierte Quantentopfschicht angrenzenden, n-leitend dotierten Barriereschichten angeordnet ist. Beispielsweise folgt die vierte Quantentopfschicht der mindestens einen ersten Quantentopfschicht nach und geht der zweiten Quantentopfschicht voraus.

Der Halbleiterchip mit der vierten Quantentopfschicht weist vorteilhafterweise eine besonders geringe Vorwärtsspannung auf. Anders ausgedrückt wird ein vorgegebener Betriebsstrom mit einer besonders geringen Betriebsspannung erzielt. Der Halbleiterchip mit mindestens einer vierten Quantentopfschicht ist beispielsweise zum Betrieb mit einem niedrigen Betriebsstrom, etwa mit einem Betriebsstrom von etwa 20 mA vorgesehen.

Bei einer Ausgestaltung enthält die Mehrfachquantentopfstruktur mindestens genauso viele erste wie dritte Quantentopfschichten. Bei einer Weiterbildung enthält sie mehr erste als dritte Quantentopfschichten. Die Erfinder haben bei umfangreichen Vergleichsversuchen festgestellt, dass der Halbleiterchip besonders effizient ist, wenn die Anzahl der ersten Quantentopfschichten größer oder gleich der Anzahl der dritten Quantentopfschichten gewählt wird.

Bei einer weiteren Ausgestaltung weist die aktive Zone höchstens zehn Quantentopfschichten auf. Vorzugsweise weist sie fünf oder mehr Quantentopfschichten auf. Der Halbleiterchip weist besonders bevorzugt zwischen sieben und neun Quantentopfschichten auf, wobei die Grenzen eingeschlossen sind. Versuche der Erfinder haben ergeben, dass ein solcher Halbleiterchip bei einem vorgegebenen Betriebsstrom einen besonders hohen Lichtstrom erzeugt. Insbesondere ist ein Sättigungsverhalten des Lichtstroms mit steigendem Betriebsstrom besonders gering ausgeprägt.

Bei einer Ausgestaltung geht der aktiven Zone in Richtung von der n-Seite zur p-Seite des Halbleiterchips ein Übergitter von Paaren alternierender Schichten voraus. Das Übergitter erstreckt sich beispielsweise über eine Schichtdicke von kleiner oder gleich 50 nm, insbesondere von kleiner oder gleich 30 nm. Beispielsweise hat es eine Schichtdicke von etwa 25 nm.

Die alternierenden Schichten des Übergitters haben beispielsweise eine Schichtdicke von kleiner oder gleich 5 nm, insbesondere haben sie eine Schichtdicke von etwa 0,5 bis 2 nm, wobei die Grenzen eingeschlossen sind. Mindestens eine Schicht jedes Paars alternierender Schichten ist n-leitend dotiert. Bei einer Ausgestaltung ist das gesamte Übergitter n-leitend dotiert.

Mittels der geringen Schichtdicke des Übergitters von 50 nm oder weniger wird eine besonders geringe Vorwärtsspannung des Halbleiterchips erzielt. Mittels der n-leitend dotierten, ersten Quantentopfschicht(en) wird auch bei der geringen Schichtdicke des Übergitters eine gute Ladungsträgerinjektion in die mindestens eine dritte Quantentopfschicht erzielt.

Die erste Quantentopfschicht, die zwei an die erste Quantentopfschicht angrenzenden Barriereschichten und/oder die an die zweite Quantentopfschicht angrenzende, n-leitend dotierte Barriereschicht ist insbesondere in einer Konzentration von größer oder gleich 1 x 10¹⁸ Atome/cm³ mit einem n-Dotierstoff dotiert. Bei einer Ausgestaltung weisen die erste Quantentopfschicht und die zwei an die erste Quantentopfschicht angrenzenden Barriereschichten den gleichen n-Dotierstoff in der gleichen Konzentration auf. Alternativ oder zusätzlich weist bei einer Weiterbildung die an die zweite Quantentopfschicht angrenzende, n-leitend dotierte Barriereschicht den n-Dotierstoff in der gleichen Konzentration auf wie die erste Quantentopfschicht und/oder wie die an die erste Quantentopfschicht angrenzenden Barriereschichten. Zwei Schichten weisen dabei den n-Dotierstoff "in der gleichen Konzentration" auf, wenn sich die Konzentration des n-Dotierstoffs zwischen den Schichten um 20 Prozent oder weniger, vorzugsweise um 10 Prozent oder weniger, zum Beispiel um 5 Prozent oder weniger unterscheidet.

Die Barriereschichten haben beispielsweise eine Schichtdicke zwischen 5 und 12 nm, vorzugsweise zwischen 6 und 11 nm, besonders bevorzugt zwischen 9 und 10,5 nm, wobei die Grenzen jeweils eingeschlossen sind. Die Quantentopfschichten haben bei einer Weiterbildung eine Schichtdicke zwischen 1 und 5 Nanometer, vorzugsweise zwischen 2 und 3 nm, wobei die Grenzen jeweils eingeschlossen sind. Beispielsweise beträgt die Schichtdicke der Barriereschichten etwa 10 nm und die Schichtdicke der Quantentopfschichten beträgt etwa 2,5 nm. Vergleichsversuche der Erfinder haben ergeben, dass der Halbleiterchip bei solchen Schichtdicken der Barriereschichten und/oder der Quantentopfschichten eine besonderes geringe Sättigung des Lichtstromes mit steigendem Betriebsstrom aufweist.

Bei einer weiteren Ausgestaltung ist der Halbleiterchip frei von einem Aufwachssubstrat. Insbesondere handelt es sich bei dem Halbleiterchip um einen Dünnfilmhalbleiterchip.

Ein Dünnfilm-Halbleiterchip zeichnet sich insbesondere durch mindestens eines der folgenden charakteristischen Merkmale aus:
- an einer zu einem Trägerelement hin gewandten ersten Hauptfläche der strahlungserzeugenden, epitaktischen Halbleiterschichtenfolge ist eine reflektierende Schicht aufgebracht oder ausgebildet, die zumindest einen Teil der in der epitaktischen Halbleiterschichtenfolge erzeugten elektromagnetischen Strahlung in diese zurückreflektiert;
- der Dünnfilmhalbleiterchip enthält ein Trägerelement, bei dem es sich nicht um das Aufwachssubstrat handelt, auf dem die Halbleiterschichtenfolge epitaktisch gewachsen wurde, sondern um ein separates Trägerelement, das nachträglich an der epitaktischen Halbleiterschichtenfolge befestigt wurde,
- das Aufwachssubstrat der epitaktischen Halbleiterschichtenfolge ist von der epitaktischen Halbleiterschichtenfolge entfernt oder derart gedünnt, dass es zusammen mit der epitaktischen Halbleiterschichtenfolge alleine nicht frei tragend ist, oder
- die epitaktische Halbleiterschichtenfolge weist eine Dicke im Bereich von 20 µm oder weniger, insbesondere im Bereich von 10 µm auf.

Das Trägerelement ist bevorzugt durchlässig für eine von dem Halbleiterchip emittierte Strahlung ausgebildet.

Weiterhin enthält die epitaktische Halbleiterschichtenfolge bevorzugt mindestens eine Halbleiterschicht mit zumindest einer Fläche, die eine Durchmischungsstruktur aufweist, die im Idealfall zu einer annähernd ergodischen Verteilung des Lichtes in der epitaktischen Halbleiterschichtenfolge führt, d.h. sie weist ein möglichst ergodisch stochastisches Streuverhalten auf.

Ein Grundprinzip eines Dünnfilm-Halbleiterchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird. Beispiele für Dünnfilm-Halbleiterchips sind in den Druckschriften EP 0905797 A2 und WO 02/13281 A1 beschrieben, deren Offenbarungsgehalt insofern hiermit durch Rückbezug aufgenommen wird.

Ein Dünnfilm-Halbleiterchip ist in guter Näherung ein Lambertscher Oberflächenstrahler und eignet sich daher insbesondere für die Anwendung in einem Scheinwerfer.

Die aktive Zone des Halbleiterchips, insbesondere die epitaktische Halbleiterschichtenfolge des Halbleiterchips basiert bei einer Ausgestaltung auf einem III-V-Verbindungshalbleitermaterial, etwa einem Nitrid-Verbindungshalbleitermaterial wie InAlGaN. Bei einer anderen Ausführungsform basiert die Halbleiterschichtenfolge auf einem II/VI-Verbindungshalbleitermaterial.

Ein III/V-Verbindungshalbleitermaterial weist wenigstens ein Element aus der dritten Hauptgruppe, wie beispielsweise A1, Ga, In, und ein Element aus der fünften Hauptgruppe, wie beispielsweise B, N, P, As, auf. Insbesondere umfasst der Begriff "III/V-Verbindungshalbleitermaterial" die Gruppe der binären, ternären oder quaternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. Eine solche binäre, ternäre oder quaternäre Verbindung kann zudem zum Beispiel ein oder mehrere Dotierstoffe sowie zusätzliche Bestandteile aufweisen.

Entsprechend weist ein II/VI-Verbindungshalbleitermaterial wenigstens ein Element aus der zweiten Hauptgruppe, wie beispielsweise Be, Mg, Ca, Sr, und ein Element aus der sechsten Hauptgruppe, wie beispielsweise O, S, Se, auf. Insbesondere umfasst ein II/VI-Verbindungshalbleitermaterial eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Beispielsweise gehören zu den II/VI-Verbindungs-Halbleitermaterialien: ZnO, ZnMgO, CdS, ZnCdS, MgBeO.

"Auf Nitrid-Verbindungshalbleitermaterial basierend" bedeutet im vorliegenden Zusammenhang, dass die Halbleiterschichtenfolge oder zumindest ein Teil davon, besonders bevorzugt zumindest die aktive Zone und/oder das Aufwachssubstrat, ein Nitrid-Verbindungshalbleitermaterial, vorzugsweise InₙAlₘGa₁₋ₙ₋ₘN aufweist oder aus diesem besteht, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters (A1, Ga, In, N), auch wenn diese teilweise durch geringe Mengen weiterer Stoffe ersetzt und/oder ergänzt sein können.

Bei einer Ausgestaltung ist der Halbleiterchip zur Emission von elektromagnetischer Strahlung mit einem Intensitätsmaximum im grünen Spektralbereich vorgesehen.

Weitere Vorteile, vorteilhafte Ausgestaltungen und Weiterbildungen des Halbleiterchips ergeben sich aus den im Folgenden in Verbindung mit den Figuren 1 bis 3 beschriebenen Ausführungsbeispielen.

### Es zeigen:

- Figur 1,: einen schematischen Querschnitt durch einen opto-elektronischen Halbleiterchip gemäß einem ersten Ausführungsbeispiel,
- Figur 2,: einen schematischen Querschnitt durch die aktive Zone des optoelektronischen Halbleiterchips gemäß dem ersten Ausführungsbeispiel und ein schematisches Konzentrationsprofil eines n-Dotierstoffs in der aktiven Zone, und
- Figur 3,: einen schematischen Querschnitt durch die aktive Zone eines optoelektronischen Halbleiterchips gemäß einem zweiten Ausführungsbeispiel und das Konzentra-tionsprofil eines n-Dotierstoffs in der aktiven Zone.

In den Figuren und Ausführungsbeispielen sind gleiche oder gleich wirkende Bestandteile mit denselben Bezugszeichen versehen. Die Figuren und die Größenverhältnisse der in den Figuren dargestellten Elemente untereinander sind grundsätzlich nicht als maßstabsgetreu zu betrachten. Vielmehr können einzelne Elemente zum besseren Verständnis und/oder zur besseren Darstellbarkeit übertrieben dargestellt sein. Beispielsweise können Schichten übertrieben groß und/oder Konzentrationsunterschiede übertrieben groß oder übertrieben klein dargestellt sein.

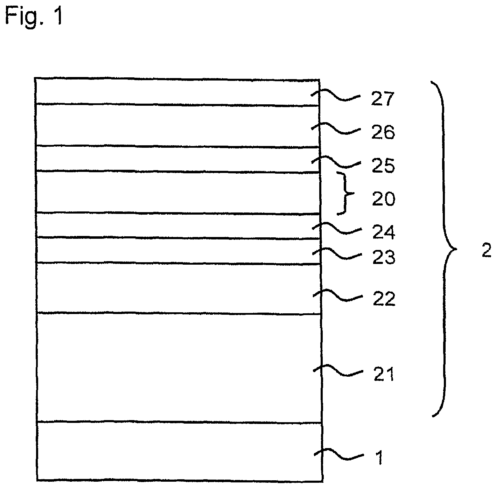

Figur 1 zeigt einen schematischen Querschnitt durch einen optoelektronischen Halbleiterchip gemäß einem ersten Ausführungsbeispiel. Der optoelektronische Halbleiterchip weist eine epitaktische Halbleiterschichtenfolge 2 auf einem Aufwachssubstrat 1 auf. Bei einer Variante des Halbleiterchips ist das Aufwachssubstrat 1 entfernt oder zumindest stark gedünnt.

Die Halbleiterschichtenfolge 2 basiert beispielsweise auf einem InAlGaN-Verbindungshalbleitermaterial. Sie ist zum Beispiel auf einem Aufwachssubstrat 1 hergestellt, das Saphir aufweist oder daraus besteht.

Die Halbleiterschichtenfolge 2 enthält mindestens eine n-Kontaktschicht 21 und eine p-Kontaktschicht 27 zwischen denen eine aktive Zone 20, die eine Mehrfachquantentopfstruktur zur Strahlungserzeugung enthält, angeordnet ist.

Vorliegend weist die Halbleiterschichtenfolge 2 im Verlauf von der n-Kontaktschicht 21 zur aktiven Zone 20 eine Stromaufweitungsschicht 22 sowie zwei weitere n-dotierte Schichten 23, 24 auf. Im Verlauf von der aktiven Zone 20 zur p-Kontaktschicht 27 weist die Halbleiterschichtenfolge 2 vorliegend zwei weitere p-dotierte Schichten 25, 26 auf. Die weiteren n-dotierten und/oder p-dotierten Schichten, oder zumindest eine oder einige dieser Schichten, sind beispielsweise Ladungsträgereinschlussschichten ("confinement layers").

Vorliegend hat die n-Kontaktschicht 21 eine Schichtdicke von 3 µm. Beispielsweise weist die n-Kontaktschicht 21 GaN auf. Sie ist vorzugsweise mit Silizium als n-Dotierstoff n-leitend dotiert, etwa mit einer Konzentration von 3 x 10¹⁸ Atome/cm³.

Die Stromaufweitungsschicht 22 hat beispielsweise eine Schichtdicke von 1 µm. Sie ist zweckmäßigerweise hoch n-dotiert, beispielsweise mit Silizium in einer Konzentration von 1 x 10¹⁹ Atome/cm³. So weist sie eine hohe elektrische Querleitfähigkeit auf.

Die beiden weiteren n-dotierten Schichten haben vorliegend jeweils eine Schichtdicke von 0,5 µm. Sie weisen beispielsweise beide mit Silizium als n-Dotierstoff n-leitend dotiertes Galliumnitrid auf. Die Siliziumkonzentration beträgt beispielsweise in der der aktiven Zone 20 zugewandten weiteren n-dotierten Schicht 24 8 x 10¹⁷ Atome/cm³. In der von der aktiven Zone 120 abgewandten, weiteren n-dotierten Schicht liegt das Silizium beispielsweise in einer Konzentration von 1 x 10¹⁸ Atome/cm³ vor.

Die p-Kontaktschicht 27 enthält beispielsweise GaN. Die weiteren p-dotierten Schichten 25, 26 enthalten zum Beispiel AlGaN. Vorliegend handelt es sich um bei der der aktiven Zone 20 zugewandten weiteren p-dotierten Schicht 25 um einen AlGaN (10% Al) Schicht und bei der von der aktiven Zone 20 abgewandten weiteren p-dotierten Schicht 26 um eine AlGaN (6% Al) Schicht. Die p-Kontaktschicht und die weiteren p-dotierten Schichten 25, 26 sind beispielsweise mit Magnesium als p-Dotierstoff dotiert.

In der p-Kontaktschicht 27 ist die Konzentration des p-Dotierstoffs vorliegend geringer als in den weiteren p-leitenden Schichten 25, 26. Beispielsweise beträgt sie in der p-Kontaktschicht 27 etwa 5 x 10¹⁹ Atome/cm³. In den weiteren p-dotierten Schichten 25, 26 liegt der p-Dotierstoff beispielsweise in einer Konzentration von größer oder gleich 6 x 10¹⁹ Atome/cm³, beispielsweise in einer Konzentration von etwa 1 x 10²⁰ Atome/cm³ vor.

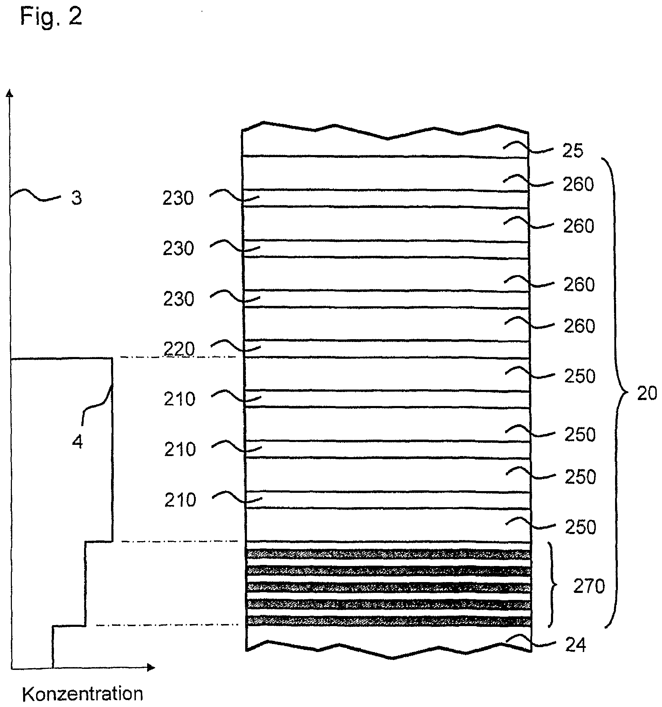

In Figur 2 ist die aktive Zone 20 der Halbleiterschichenfolge 2 vergrößert gezeigt. Im rechten Bereich der Figur 2 ist die aktive Zone 20 in einem schematischen Querschnitt dargestellt. Der linke Bereich der Figur 2 zeigt schematisch die Konzentration 4 des n-Dotierstoffs der im rechten Bereich abgebildeten Schichten. Der Pfeil 3 bezeichnet die Richtung von einer n-Seite zu einer p-Seite der Halbleiterschichtenfolge 2 zwischen denen die aktive Zone 20 angeordnet ist, also insbesondere die Richtung von der n-Kontaktschicht 21 zur p-Kontaktschicht 27.

Die aktive Zone 20 des Halbleiterchips gemäß dem ersten Ausführungsbeispiel weist eine Quantentopfstruktur mit sieben Quantentopfschichten 210, 220, 230 auf. In der Richtung 3 von der n- zur p-Seite folgen drei erste Quantentopfschichten 210, eine zweite Quantentopfschicht 220 und drei dritte Quantentopfschichten 230 aufeinander.

Je zwei benachbarte Quantentopfschichten 210, 220, 230 sind durch eine Barriereschicht 250, 260 voneinander getrennt. Eine der Barriereschichten 250 geht der ersten der ersten Quantentopfschichten 210 voraus. Eine weitere der Barriereschichten 260 folgt der letzten der dritten Quantentopfschicht 230 nach. Auf diese Weise ist jede der Quantentopfschichten 210, 220, 230 zwischen genau zwei Barriereschichten 250, 260 angeordnet.

Den Quantentopfschichten 210, 220, 230 und den Barriereschichten 250, 260 geht eine Übergitterstruktur 270 voraus. Die Übergitterstruktur 270 besteht aus Paaren von alternierenden InGaN- und GaN-Schichten, die beispielsweise jeweils eine Schichtdicke von kleiner oder gleich 1 nm haben. Sie sind beispielsweise mit einer Konzentration von 1,5 x 10¹⁸ Atome/cm³ mit Silizium als n-Dotierstoff dotiert.

Die drei der Übergitterstruktur 270 nachfolgenden ersten Quantentopfschichten 10 und die diesen zugeordneten Barriereschichten 250, zwischen denen die ersten Quantentopfschichten 210 angeordnet sind, sind ebenfalls mit Silizium als n-Dotierstoff dotiert, beispielsweise in einer Konzentration zwischen 1 x 10¹⁸ Atome/cm³ und 8 x 10¹⁸ Atome/cm³, insbesondere zwischen 2 x 10¹⁸ und 4 x 10¹⁸ Atome/cm³, wobei die Grenzen jeweils eingeschlossen sind.

Auf die ersten Quantentopfschichten 210 folgt die zweite Quantentopfschicht 220, der eine Barriereschicht 250 vorausgeht, welche auch einer ersten Quantentopfschicht 210 zugeordnet ist. Die der zweite Quantentopfschicht 220 vorausgehende Barriereschicht 250 ist n-dotiert. Die der zweiten Quantentopfschicht 220 nachfolgende Barriereschicht 260 ist, wie die zweite Quantentopfschicht 220 selbst, undotiert.

Nachfolgend auf die zweite Quantentopfschicht 220 sind drei dritte Quantentopfschichten 230 zwischen je zwei undotierten Barriereschichten 260 angeordnet.

Der Halbleiterchip ist zum Betrieb mit einem Betriebsstrom von beispielsweise 80 mA vorgesehen. Ein Großteil, insbesondere praktisch die gesamte von dem Halbleiterchip emittierte elektromagnetische Strahlung wird in mindestes einer, vorzugsweise mehreren, insbesondere allen, der dritten Quantentopfschichten 230 oder in den dritten Quantentopfschichten 230 und der zweiten Quantentopfschicht 220 erzeugt. Die ersten Quantentopfschichten 210 tragen nicht oder kaum zur Strahlungserzeugung bei.

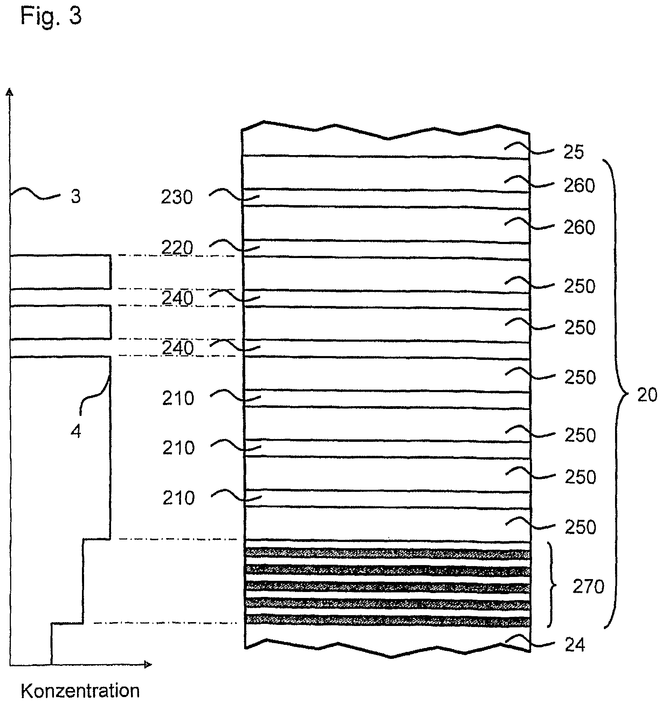

In Figur 3 ist die aktive Zone 20 eines Halbleiterchips gemäß einem zweiten Ausführungsbeispiel im schematischen Querschnitt dargestellt. Im linken Bereich ist wiederum das Konzentrationsprofil des n-Dotierstoffs der im rechten Bereich dargestellten Schichten schematisch aufgetragen.

Der Halbleiterchip gemäß dem zweiten Ausführungsbeispiel unterscheidet sich von dem des ersten Ausführungsbeispiels dadurch, dass die aktive Zone 20 lediglich eine einzige dritte Quantentopfschicht 230 enthält. Zudem enthält sie zwei vierte Quantentopfschichten 240, die den ersten Quantentopfschichten 210 nachfolgen und der zweiten Quantentopfschicht 220 vorausgehen. Insgesamt enthält also auch die aktive Zone 20 bei dem zweiten Ausführungsbeispiel sieben Quantentopfschichten 210, 220, 230, 240.

Die vierten Quantentopfschichten 240 sind undotiert. Jede der vierten Quantentopfschichten 240 ist zwischen zwei angrenzenden mit dem n-Dotierstoff dotierten Barriereschichten 250 angeordnet. Vorliegend hat der n-Dotierstoff in allen Barriereschichten 250, die mit dem n-Dotierstoff dotiert sind, und in den ersten Quantentopfschichten 210 die gleiche Konzentration.

Der Halbleiterchip gemäß dem zweiten Ausführungsbeispiel ist insbesondere zum Betrieb mit einem Betriebsstrom von etwa 20 mA vorgesehen.

## Patentansprüche

1. Optoelektronischer Halbleiterchip mit
- einer aktiven Zone (20), die eine zur Erzeugung von elektromagnetischer Strahlung vorgesehene Mehrfachquantentopfstruktur enthält, welche eine Mehrzahl von aufeinander folgenden Quantentopfschichten (210, 220, 230) enthält, wobei die Mehrfachquantentopfstruktur mindestens eine erste Quantentopfschicht (210), die n-leitend dotiert ist, und eine zweite Quantentopfschicht (220), die undotiert ist, sowie mindestens eine dritte Quantentopfschicht (230) aufweist, und
- einer Mehrzahl von n-leitend dotierten Barriereschichten (250) und undotierten Barriereschichten (260),
**dadurch gekennzeichnet, dass**
- die erste Quantentopfschicht (210) zwischen zwei an die erste Quantentopfschicht (210) angrenzenden, n-leitend dotierten Barriereschichten (250) angeordnet ist,
- die zweite Quantentopfschicht (220) zwischen zwei an die zweite Quantentopfschicht angrenzenden Barriereschichten (250, 260) angeordnet ist, von denen eine n-leitend dotiert und die andere undotiert ist, und
- die dritte Quantentopfschicht (230) undotiert ist und zwischen zwei an die dritte Quantentopfschicht angrenzenden, undotierten Barriereschichten (260) angeordnet ist.

2. Optoelektronischer Halbleiterchip gemäß Anspruch 1, bei dem die mindestens eine erste, die zweite und die mindestens eine dritte Quantentopfschicht (210, 220, 230) in Richtung von einer n-Seite zu einer p-Seite des Halbleiterchips in dieser Reihenfolge aufeinander folgen.

3. Optoelektronischer Halbleiterchip gemäß Anspruch 1 oder 2, bei dem die Mehrfachquantentopfstruktur mindestens eine vierte Quantentopfschicht (240) aufweist, die undotiert ist und die zwischen zwei an die vierte Quantentopfschicht angrenzenden, n-leitend dotierten Barriereschichten (250) angeordnet ist.

4. Optoelektronischer Halbleiterchip gemäß einem der vorhergehenden Ansprüche, der genauso viele erste (210) wie dritte Quantentopfschichten (230) oder mehr erste (210) als dritte Quantentopfschichten (230) enthält.

5. Optoelektronischer Halbleiterchip gemäß einem der vorhergehenden Ansprüche, bei dem die aktive Zone (20) höchstens zehn Quantentopfschichten (210, 220, 230, 240) aufweist.

6. Optoelektronischer Halbleiterchip gemäß einem der vorhergehenden Ansprüche, der ein der aktiven Zone (20) in Richtung von einer n-Seite zu einer p-Seite des Halbleiterchips vorausgehendes Übergitter (270) von Paaren alternierender Schichten aufweist, das eine Dicke von kleiner oder gleich 50 nm hat.

7. Optoelektronischer Halbleiterchip gemäß Anspruch 6, bei dem mindestens eine Schicht jedes Paars alternierender Schichten n-leitend dotiert ist.

8. Optoelektronischer Halbleiterchip gemäß einem der vorhergehenden Ansprüche, bei dem die mindestens eine erste Quantentopfschicht (210) und/oder die zwei an die erste Quantentopfschicht (210) angrenzenden Barriereschichten (250) einen n-Dotierstoff in einer Konzentration (4) von größer oder gleich 1 x 10¹⁸ Atome/cm³ enthalten.

9. Optoelektronischer Halbleiterchip gemäß einem der vorhergehenden Ansprüche, bei dem eine Schichtdicke der Barriereschichten (250, 260) jeweils einen Wert zwischen 9,5 nm und 10,5 nm hat, wobei die Grenzen eingeschlossen sind.

10. Optoelektronischer Halbleiterchip gemäß einem der vorhergehenden Ansprüche, bei dem eine Schichtdicke der Quantentopfschichten (210, 220, 230, 240) jeweils einen Wert zwischen 2 nm und 3 nm hat, wobei die Grenzen eingeschlossen sind.

11. Optoelektronischer Halbleiterchip gemäß einem der vorhergehenden Ansprüche, der frei von einem Aufwachssubstrat ist.

12. Optoelektronischer Halbleiterchip gemäß einem der vorhergehenden Ansprüche, bei dem die aktive Zone (20) auf einem InGaN-Verbindungshalbleitermaterial basiert.

13. Optoelektronischer Halbleiterchip gemäß einem der vorhergehenden Ansprüche, der zur Emission von elektromagnetischer Strahlung mit einem Intensitätsmaximum im grünen Spektralbereich vorgesehen ist.

14. Optoelektronischer Halbleiterchip gemäß einem der Ansprüche 3 bis 13, bei dem die aktive Zone (20) eine einzige dritte Quantentopschicht (230) sowie zwei vierte Quantentopfschichten (240) enthält, die den ersten Quantentopfschichten (210) nachfolgen und der zweiten Quantentopfschicht (220) vorausgehen.

15. Optoelektronischer Halbleiterchip gemäß Anspruch 1, bei dem die Mehrfachquantentopfstruktur mindestens eine vierte Quantentopfschicht (240) aufweist, die undotiert ist und zwischen zwei an die vierte Quantentopfschicht angrenzenden, n-leitend dotierten Barriereschichten (250) angeordnet ist, wobei die vierte Quantentopfschicht (240) der mindestens einen ersten Quantentopfschicht (210) nachfolgt und der zweiten Quantentopfschicht (220) vorausgeht.

## Claims

1. An optoelectronic semiconductor chip with
- an active zone (20), the active zone containing a multi quantum well structure provided for generating electromagnetic radiation, which contains a plurality of successive quantum well layers (210, 220, 230), the multi quantum well structure comprising at least one first quantum well layer (210), which is n-conductively doped, and one second quantum well layer (220), which is undoped, as well as one third quantum well layer (230), and
- a plurality of n-conductively doped barrier layers (250) and undoped barrier layers (260),
**characterized in that**
- the first quantum well layer (210) is arranged between two n-conductively doped barrier layers (250) adjoining the first quantum well layer (210),
- the second quantum well layer (220) is arranged between two barrier layers (250, 260) adjoining the second quantum well layer, of which one is n-conductively doped and the other is undoped, and
- the third quantum well layer (230) is undoped and is arranged between two undoped barrier layers (260) adjoining the third quantum well layer.

2. The optoelectronic semiconductor chip according to claim 1, in which the at least one first, the second and the at least one third quantum well layer (210, 220, 230) succeed one another in this sequence in the direction extending from an n-side to a p-side of the semiconductor chip.

3. The optoelectronic semiconductor chip according to claim 1 or 2, in which the multi quantum well structure comprises at least one fourth quantum well layer (240), which is undoped and is arranged between two n-conductively doped barrier layers (250) adjoining the fourth quantum well layer.

4. The optoelectronic semiconductor chip according to any one of the preceding claims, which contains exactly the same number of first (210) as third quantum well layers (230) or more first (210) than third quantum well layers (230) .

5. The optoelectronic semiconductor chip according to any one of the preceding claims, in which the active zone (20) comprises at most ten quantum well layers (210, 220, 230, 240).

6. The optoelectronic semiconductor chip according to any one of the preceding claims, which comprises a superlattice (270) of pairs of alternating layers preceding the active zone (20) in the direction from an n-side to a p-side of the semiconductor chip, which superlattice has a thickness of less than or equal to 50 nm.

7. The optoelectronic semiconductor chip according to claim 6, in which at least one layer of each pair of alternating layers is n-conductively doped.

8. The optoelectronic semiconductor chip according to any one of the preceding claims, in which the at least one first quantum well layer (210) and/or the two barrier layers (250) adjoining the first quantum well layer (210) contain an n-dopant in a concentration (4) of greater than or equal to 1 x 10¹⁸ atoms/cm³.

9. The optoelectronic semiconductor chip according to any one of the preceding claims, in which the layer thickness of the barrier layers (250, 260) in each case has a value of between 9.5 nm and 10.5 nm, the limit values being included.

10. The optoelectronic semiconductor chip according to any one of the preceding claims, in which the layer thickness of the quantum well layers (210, 220, 230, 240) in each case has a value of between 2 nm and 3 nm, the limit values being included.

11. The optoelectronic semiconductor chip according to any one of the preceding claims, which is free of a growth substrate.

12. The optoelectronic semiconductor chip according to any one of the preceding claims, in which the active zone (20) is based on an InGaN compound semiconductor material.

13. The optoelectronic semiconductor chip according to any one of the preceding claims, which is provided for the emission of electromagnetic radiation with an intensity maximum in the green spectral range.

14. The optoelectronic semiconductor chip according to one of claims 3 through 13, wherein the active zone (20) has one single third quantum well layer (230) and two fourth quantum well layers (240) which succeed the first quantum well layers (210) and precede the second quantum well layer (220).

15. The optoelectronic semiconductor chip according claim 1, wherein the multi quantum well structure comprises at least one fourth quantum well layer (240) which is undoped and is arranged between two n-conductively doped barrier layers (250) adjoining the fourth quantum well layer, wherein the fourth quantum well layer (240) succeeds the at least one first quantum well layer (210) and precedes the second quantum well layer (220).

## Revendications

1. Puce semi-conductrice optoélectronique avec
- une zone active (20), qui contient une structure à puits quantiques multiples prévue pour la génération de rayonnement électromagnétique, qui comprend une pluralité de couches de puits quantique successives (210, 220, 230), la structure à puits quantiques multiples présentant au moins une première couche de puits quantique (210), qui est dopée à conduction type n, et une seconde couche de puits quantique (220), qui est non dopée, ainsi qu'au moins une troisième couche de puits quantique (230), et
- une pluralité de couches barrières dopées à conduction type n (250) et de couches barrières non dopées (260),
**caractérisée en ce que**
- la première couche de puits quantique (210) est disposée entre deux couches barrières (250) dopées à conduction type n adjacentes à la première couche de puits quantique (210),
- la seconde couche de puits quantique (220) est disposée entre deux couches barrières (250, 260) adjacentes à la seconde couche de puits quantique, dont une est dopée à conduction type n et l'autre non dopée, et
- la troisième couche de puits quantique (230) est non dopée et est disposée entre deux couches barrières (260) non dopées adjacentes à la troisième couche de puits quantique.

2. Puce semi-conductrice optoélectronique selon la revendication 1, pour laquelle au moins l'unique première, la deuxième et au moins l'unique troisième couche de puits quantique (210, 220, 230) se succèdent dans la direction d'un côté n vers un côté p de la puce semi-conductrice optoélectronique et dans cet ordre.

3. Puce semi-conductrice optoélectronique selon la revendication 1 ou 2, pour laquelle la structure à puits quantiques multiples présente au moins une quatrième couche de puits quantique (240), qui est non dopée et qui est disposée entre deux couches barrières (250) dopées à conduction type n adjacentes à la quatrième couche de puits quantique.

4. Puce semi-conductrice optoélectronique selon une quelconque des revendications précédentes, qui contient autant de premières (210) que de troisièmes couches de puits quantique (230) ou plus de premières (210) que de troisièmes couches de puits quantique (230).

5. Puce semi-conductrice optoélectronique selon une quelconque des revendications précédentes, pour laquelle la zone active (20) présente au maximum dix couches de puits quantique (210, 220, 230, 240).

6. Puce semi-conductrice optoélectronique selon une quelconque des revendications précédentes, qui présente un super-réseau (270) de paires de couches alternantes précédant la zone active (20) dans la direction d'un côté n vers un côté p de la puce semi-conductrice, qui a une épaisseur inférieure ou égale à 50 nm.

7. Puce semi-conductrice optoélectronique selon la revendication 6, pour laquelle au moins une couche de chaque paire de couches alternantes est dopée à conduction type n.

8. Puce semi-conductrice optoélectronique selon une quelconque des revendications précédentes, pour laquelle au moins l'unique première couche de puits quantique (210) et/ou les deux couches barrières (250) adjacentes à la première couche de puits quantique (210) contiennent une impureté de dopage n dans une concentration (4) supérieure ou égale à 1 x 10¹⁸ atomes/cm³.

9. Puce semi-conductrice optoélectronique selon une quelconque des revendications précédentes, pour laquelle une épaisseur de couche des couches barrières (250, 260) a respectivement une valeur entre 9,5 nm et 10,5 nm, les limites étant incluses.

10. Puce semi-conductrice optoélectronique selon une quelconque des revendications précédentes, pour laquelle une épaisseur de couche des couches de puits quantique (210, 220, 230, 240) a respectivement une valeur entre 2 nm et 3 nm, les limites étant incluses.

11. Puce semi-conductrice optoélectronique selon une quelconque des revendications précédentes, qui est exempte d'un substrat de phase vapeur.

12. Puce semi-conductrice optoélectronique selon une quelconque des revendications précédentes, pour laquelle la zone active (20) se base sur un matériau de semi-conducteur de liaison InGaN.

13. Puce semi-conductrice optoélectronique selon une quelconque des revendications précédentes, qui est prévue pour l'émission de rayonnement électromagnétique avec un maximum d'intensité dans la région spectrale verte.

14. Puce semi-conductrice optoélectronique selon une quelconque des revendications 3 à 13, pour laquelle la zone active (20) contient une seule troisième couche de puits quantique (230) ainsi que deux quatrièmes couches de puits quantique (240), qui suivent les premières couches de puits quantique (210) et précèdent la deuxième couche de puits quantique (220).

15. Puce semi-conductrice optoélectronique selon la revendication 1, pour laquelle la structure à puits quantiques multiples présente au moins une quatrième couche de puits quantique (240), qui est non dopée et qui est disposée entre deux couches barrières (250) dopées à conduction type n adjacentes à la quatrième couche de puits quantique, la quatrième couche de puits quantique (240) suivant au moins une première couche de puits quantique (210) et précédant la seconde couche de puits quantique (220).
